# EUROPEAN PATENT APPLICATION

(11) **EP 2 822 014 A1**
(43) Date of publication of application: **07.01.2015**
(21) Application number: 14172526.7
(22) Date of filing: 16.06.2014
(51) Int. Cl.: H01H 9/04, H05K 5/06, H01H 9/06

(54) **Sealed casing and production method thereof**

(30) Priority: 02.07.2013 JP 2013139182
(71) Applicant: OMRON CORPORATION, Kyoto-shi, Kyoto 600-8530 (JP)
(72) Inventor: Hozumi, Akihiro, Okayama, Okayama 703-8502 (JP)
(74) Representative: Kilian Kilian & Partner

(57) **Abstract**

A strength of a sealed casing used in an electrical instrument is improved. Casing 2 inludes at least first casing member 2a and second casing member 2b. Casing 2 is formed by welding welding part 22a of first casing member 2a and second casing member 2b by ultrasonic welding, and welding part 22a includes a surface oblique to an ultrasonic vibration direction. Casing 2 also includes burr reservoir 23 in which a burr generated by the ultrasonic welding is reserved. Burr reservoir 23 is located below welding part 22a and between first casing member 2a and second casing member 2b.

## Description

### BACKGROUND

### 1. FIELD

The present invention relates to a sealed casing that protects an electrical instrument and a method for producing the sealed casing.

### 2. RELATED ART

Conventionally, there are various techniques of ensuring sealability of the casing that protects the electrical instrument. For example, in Japanese Unexamined Patent Publication No. 2000-268663, the casing of a sealed type compact switch includes a housing and a base, and the housing and the base are joined to each other by ultrasonic welding.

Nowadays, in order to achieve downsizing, weight reduction, and cost reduction of the electrical instrument, a thin casing is used to protect the electrical instrument. For the casing of an electric tool or the electrical instrument mounted on a vehicle, it is necessary to enhance sealability of the casing to improve dustproofness and waterproofness, and it is necessary to ensure strength to withstand vibration or shock on the casing.

However, in the joining method of Japanese Unexamined Patent Publication No. 2000-268663, because a welding surface between the housing and the base is oriented toward an identical direction at any portion, the casing has a structure vulnerable to a force parallel to the welding surface.

### SUMMARY

An object of the present invention is to provide a sealed casing, which is used in an electrical instrument while the strength is improved, and a method for producing the sealed casing.

In accordance with one aspect of the present invention, a sealed casing that is used in an electrical instrument includes: a first member; a second member; and a burr reservoir in which a burr generated by ultrasonic welding is reserved, the burr reservoir being located in a burr outflow direction in which the burr flows out from a welding part of the first member, the burr reservoir being a gap between the first member and the second member. The sealed casing is formed by welding the welding part and the second member by the ultrasonic welding, the welding part including a surface oblique to an ultrasonic vibration direction.

At this point, a welding surface between the first member and the second member is formed so as to surround an inside of the sealed casing. Additionally, the welding surface is oblique to the ultrasonic vibration direction. Therefore, the direction of the welding surface varies depending on a place in the sealed casing. Accordingly, advantageously the sealed casing can withstand forces from all directions.

According to the configuration, the gap formed between the first member and the second member constitutes the burr reservoir. Therefore, shapes of the first member and the second member can simply be designed compared with the case that the burr reservoir is formed in the first member or the second member.

A surface of the first member may be flush with a contact surface of the first member, the surface of the first member being a bottom surface of the burr reservoir, the contact surface of the first member coming into contact with the second member to specify a positional relationship between the first member and the second member.

According to the configuration, compared with the case that a recess is provided in the first member to form the burr reservoir, the first member can be formed into the simple shape having less unevenness. Therefore, a metal mold for the first member can be formed into the simple shape, and a lifetime of the metal mold for the first member can be lengthened.

The burr reservoir may be located in an outer side in the sealed casing with respect to the welding part.

According to the configuration, the burr reservoir is located in the outer side in the sealed casing with respect to the welding part, so that the burr can be prevented from leaking into the sealed casing.

The first member may include a projecting portion that extends from the welding part toward a direction opposite to the burr outflow direction, the projecting portion being located in an inner side in the sealed casing with respect to the welding part.

According to the configuration, the projecting portion extending from the welding part to the direction opposite to the burr outflow direction is located inside the sealed casing with respect to the welding part, so that the burr can be prevented from leaking into the sealed casing.

In accordance with another aspect of the present invention, a sealed casing that is used in an electric tool includes: a first member; and a second member. The sealed casing is formed by welding a welding part of the first member and the second member by ultrasonic welding, the welding part including a surface oblique to an ultrasonic vibration direction.

At this point, the welding surface between the first member and the second member is formed so as to surround the inside of the sealed casing. Additionally, the welding surface is oblique to the ultrasonic vibration direction. Therefore, the direction of the welding surface varies depending on the place in the sealed casing. Accordingly, advantageously the sealed casing can withstand forces from all directions.

In accordance with still another aspect of the present invention, a method for producing a sealed casing used in an electrical instrument includes a step of forming the sealed casing by welding a first member and a second member by ultrasonic welding, the first member including: a first welding part that includes a surface oblique to an ultrasonic vibration direction; and a first burr reservoir forming part configured to form a gap with the second member as a burr reservoir after the ultrasonic welding, the first burr reservoir forming part being located in a burr outflow direction in which a burr generated by the ultrasonic welding flows out to the first welding part, the second member including: a second welding part that is welded to the first welding part; and a second burr reservoir forming part configured to form the gap with the first burr reservoir forming part as the burr reservoir after the ultrasonic welding.

According to the present invention, the strength of the sealed casing used in an electrical instrument is advantageously improved.

### BRIEF DESCRIPTION OF THE DRAWINGS

Fig. 1 is a perspective view illustrating a configuration of a trigger switch according to a first embodiment of the present invention;
Fig. 2 is a front view illustrating the configuration of the trigger switch;
Fig. 3 is a sectional view illustrating first and second casing members constituting a casing of the trigger switch, and a state in which the first and second casing members are separated from each other;
Fig. 4 is a sectional view illustrating the first and second casing members constituting the casing of the trigger switch, and a state in which the pre-welding first and second casing members are fitted in each other;
Fig. 5 is a sectional view illustrating the first and second casing members constituting the casing of the trigger switch, and a state after the first and second casing members are welded to each other;
Fig. 6 is a flowchart illustrating a method for producing the casing of the trigger switch; and
Fig. 7 is a sectional view illustrating first and second casing members constituting a casing of a trigger switch according to a second embodiment of the present invention, and a state after the first and second casing members are welded to each other.

### DETAILED DESCRIPTION

Hereinafter, exemplary embodiments of the present invention will be described in detail with reference to the drawings. In the description, a casing of an electric tool is described by way of example. More particularly, a casing of a trigger switch that is of a switch controlling power supplied to a motor of an electric tool is illustrated. However, the casing to which the present invention is applied is not limited to the casing of the trigger switch, but the present invention can be applied to any casing that protects electrical instruments such as an in-vehicle electrical instrument. Additionally, the present invention is not limited to the casing of the switch, but the present invention may be applied to a casing of another member constituting the electric tool. The present invention may be applied to a casing of the whole electric tool.

### <First Embodiment>

### (Configuration of trigger switch)

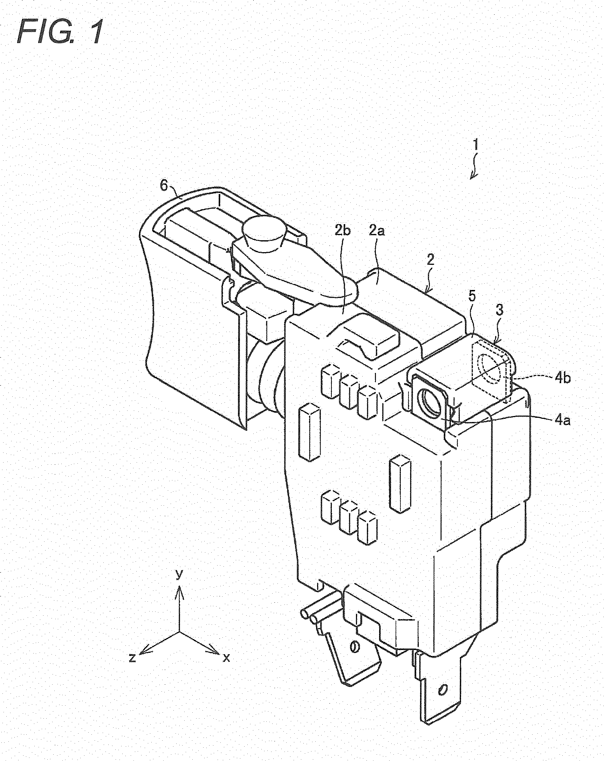

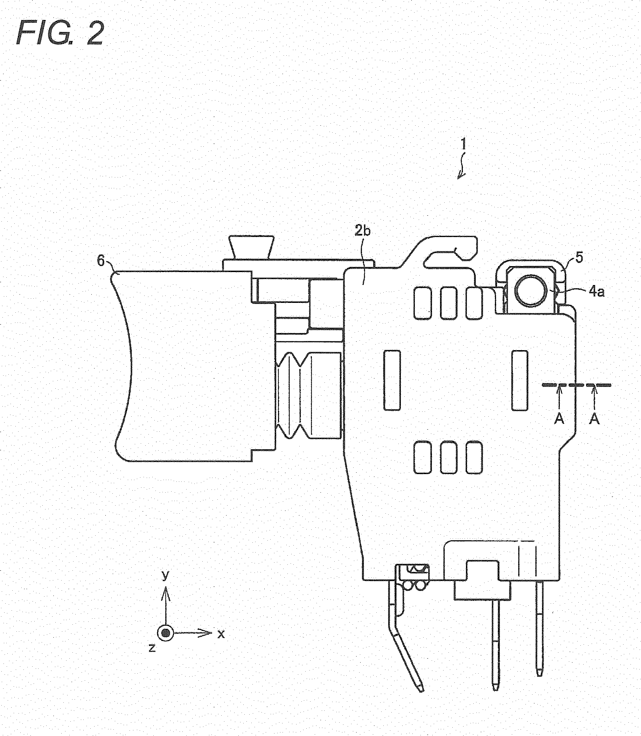

Fig. 1 is a perspective view illustrating a configuration of trigger switch 1 according to a first embodiment. Fig. 2 is a front view illustrating the configuration of trigger switch 1 of the first embodiment. Trigger switch 1 (switch unit) includes casing (sealed casing) 2 provided with a switch and a wiring board connected to the switch, terminal unit 3, and operation unit 6 (trigger) that turns on and off the switch from an outside of casing 2. Casing 2 is constructed with a combination of first casing member (first member: case) 2a and second casing member (second member: cover) 2b, which are of two casing members.

Terminal unit 3 includes external terminals 4a and 4b and pressing member 5. For example, external terminals 4a and 4b are terminals that are connected to lead wires connected to a motor of the electric tool. External terminals 4a and 4b project to the outside of casing 2. External terminals 4a and 4b are symmetrically located with respect to pressing member 5. External terminals 4a and 4b are connected to such an electric component as a switch and a wiring board in casing 2.

### (Configurations of first and second casing members)

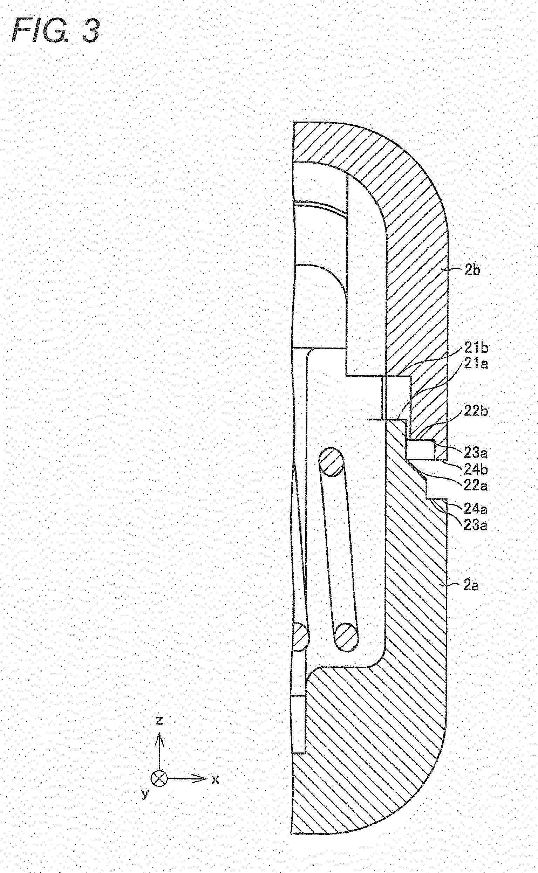

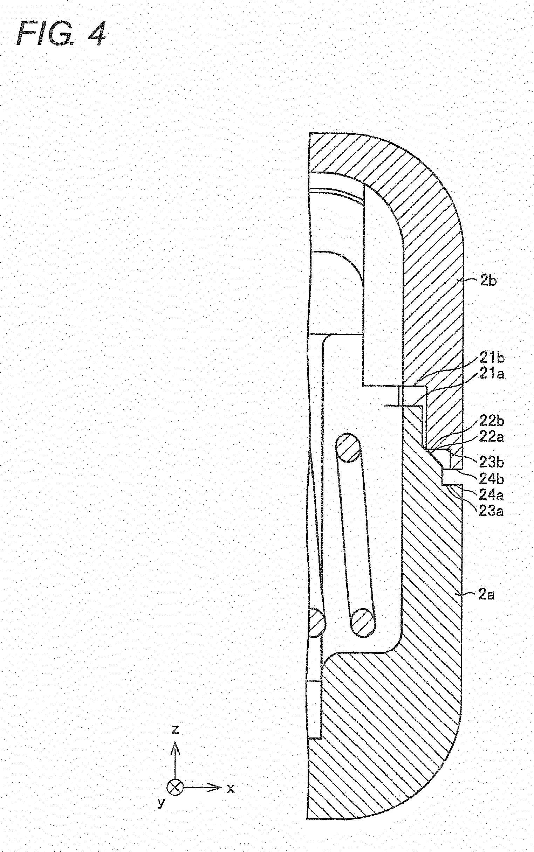

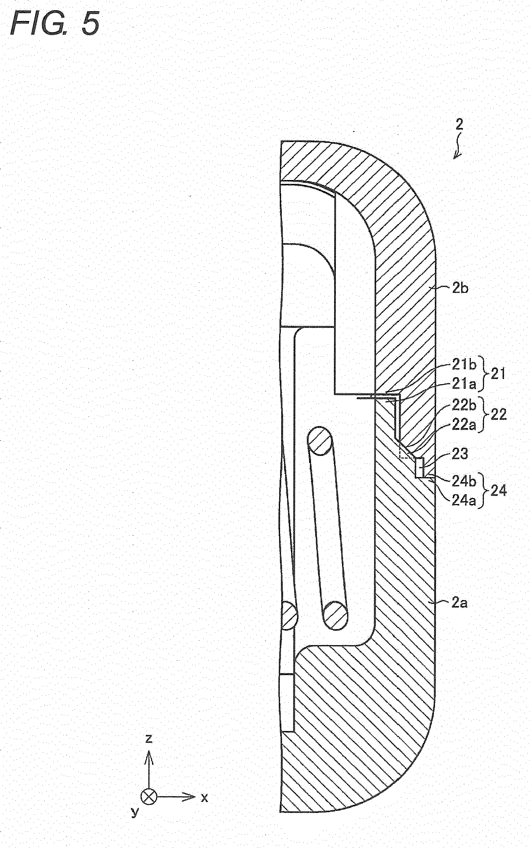

The configurations of first casing member 2a and second casing member 2b will be described below with reference to Figs. 3 to 5. Figs. 3 to 5 are sectional views taken on line A-A in Fig. 2, and illustrate first casing member 2a and second casing member 2b. Fig. 3 illustrates a state in which first casing member 2a and second casing member 2b are separated from each other, Fig. 4 illustrates a state (fitted state) in which the pre-welding first casing member 2a and second casing member 2b are fitted in each other, and Fig. 5 illustrate a state (welded state) after first casing member 2a and second casing member 2b are welded to each other.

As illustrated in Figs. 3 and 4, first casing member 2a includes engagement part (first engagement part, projecting portion) 21a, welding part (first welding part) 22a, burr reservoir forming part (first burr reservoir forming part) 23a, and contact part (first contact part) 24a. Second casing member 2b includes engagement part (second engagement part) 21b, welding part (second welding part) 22b, burr reservoir forming part (second burr reservoir forming part) 23b, and contact part (second contact part) 24b.

As illustrated in Fig. 5, casing 2 includes engagement part 21, welding part 22, burr reservoir 23, and contact part 24. Engagement part 21a and engagement part 21 b are engaged with each other in engagement part 21. Welding part 22 is formed by welding partially melted welding part 22a and welding part 22b by ultrasonic welding. Burr reservoir 23 is formed by burr reservoir forming part 23a and burr reservoir forming part 23b. Contact part 24a and contact part 24b are in contact with each other in contact part 24.

Engagement part 21a and engagement part 21b are engaged with each other. Engagement part 21a has a shape projected in a positive direction of a Z-axis, and engagement part 21 b has a recessed shape. Engagement part 21a is located in an inner side in casing 2 with respect to welding part 22a, and extends upward (in a direction opposite to a burr outflow direction (described in detail later)) from welding part 22a. Therefore, a burr can be prevented from leaking into casing 2 when first casing member 2a and second casing member 2b are welded to each other. As illustrated in Figs. 4 and 5, in the fitted state and the welded state, surfaces (vertical surfaces and horizontal surfaces) of engagement part 21a and engagement part 21b are not in contact with each other while being opposed to each other, but engagement part 21 may include a gap (clearance).

Welding part 22a and welding part 22b are partially melted and welded to each other by the ultrasonic welding. Welding part 22a includes a surface oblique to an ultrasonic vibration direction (Z-axis direction). In other words, welding part 22a includes the surface oblique to a reference surface (described in detail later) of contact part 24a. The oblique surface of welding part 22a preferably ranges from 30 degrees to 60 degrees with respect to the Z-axis (or X-axis). Welding part 22b has a stepwise projected shape. Welding part 22b may include an oblique surface that is in surface contact with the oblique surface of welding part 22a. In the fitted state, welding part 22a and welding part 22b abut on each other, and the oblique surface of welding part 22a is in line contact with an end portion of welding part 22b.

When welding part 22a includes the oblique surface, a force in the direction (in the drawings, the X-axis direction) perpendicular to the ultrasonic vibration direction (Z-axis direction) is not matched with shear directions of first casing member 2a and second casing member 2b. Therefore, casing 2 can have the strength against the force in the direction perpendicular to the ultrasonic vibration direction. Although the sectional structure of one sidewall of casing 2 is illustrated in the first embodiment, all the sidewalls of casing 2 may have the sectional structure in Fig. 5. In this case, casing 2 has a structure in Fig. 5 in which first casing member 2a and second casing member 2b are connected to each other in all the sidewalls. Therefore, even if the force in which the direction is matched with the shear direction is applied to casing 2 in a certain sidewall, the direction of the force is not matched with the shear direction in other sidewalls, so that casing 2 can have the strength against the force in any direction.

Burr reservoir forming part 23a and burr reservoir forming part 23b form burr reservoir 23 after first casing member 2a and second casing member 2b are welded to each other. Burr reservoir 23 is the gap formed between burr reservoir forming part 23a and burr reservoir forming part 23b. After the welding, the whole or part of burr reservoir 23 is filled with the burr generated from the melting of welding part 22a and welding part 22b. Preferably a volume of burr reservoir 23 is larger than the amount of burr generated from the melting of welding part 22a and welding part 22b. Burr reservoir 23 is located below welding part 22 (a negative direction of the Z-axis). The burr generated by the ultrasonic welding flows out below welding part 22 (in the gravitational direction), namely, burr reservoir 23 is located in the burr outflow direction in which the burr flows out from welding part 22. Preferably burr reservoir 23 is provided in an outer side in casing 2 with respect to welding part 22 (the positive direction of the X-axis). Therefore, the burr generated by the ultrasonic welding can be prevented from leaking into casing 2. Even if the burr is generated exceeding the volume of burr reservoir 23, because the burr leaks to the outside of the casing, a burr removing process can easily be performed without soiling the inside of casing 2.

Contact part 24a includes a contact surface that comes into contact with contact part 24b. Contact part 24b has the projected shape, and a leading end surface of contact part 24b comes into surface contact with contact part 24a. The contact surface of contact part 24a is the reference surface that specifies a positional relationship between first casing member 2a and second casing member 2b after the welding. That is, contact part 24a has a function of a stopper that specifies an intrusion amount of second casing member 2b during the welding. The contact surface of contact part 24a is flush with the surface of burr reservoir forming part 23a, and the surface of burr reservoir forming part 23a is a bottom surface of burr reservoir 23. Therefore, a metal mold used to form first casing member 2a can be formed into the simple shape having less unevenness compared with the case burr reservoir 23 is formed into the recessed shape. In order to form burr reservoir 23, a width in the X-axis direction of the leading end surface of contact part 24b is larger than that in the X-axis direction of the surface formed by burr reservoir forming part 23a and contact part 24a.

In the first embodiment, engagement part 21a, burr reservoir forming part 23a, and contact part 24a of first casing member 2a and engagement part 21 b, welding part 22b, burr reservoir forming part 23b, and contact part 24b of second casing member 2b are formed as the vertical surface or the horizontal surface (YZ-plane or XY-plane). Alternatively, these parts may have an angle with respect to the vertical surface or the horizontal surface.

### (Casing producing method)

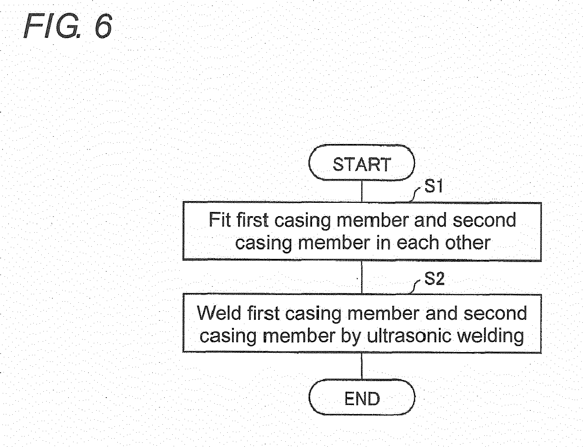

A method for producing casing 2 will be described with reference to Fig. 6. Fig. 6 is a flowchart illustrating the method for producing casing 2 of the first embodiment.

As illustrated in Fig. 6, first casing member 2a and second casing member 2b are fitted in each other first (S1) as illustrated in Fig. 4. In the fitted state, welding part 22a of first casing member 2a and welding part 22b of second casing member 2b are welded to each other by applying a pressurizing force to second casing member 2b at the same time as an ultrasonic vibration (S2).

In the case that the burr leaks to the outside of casing 2 after the welding, casing 2 is shaped by removing the burr.

### <Second Embodiment>

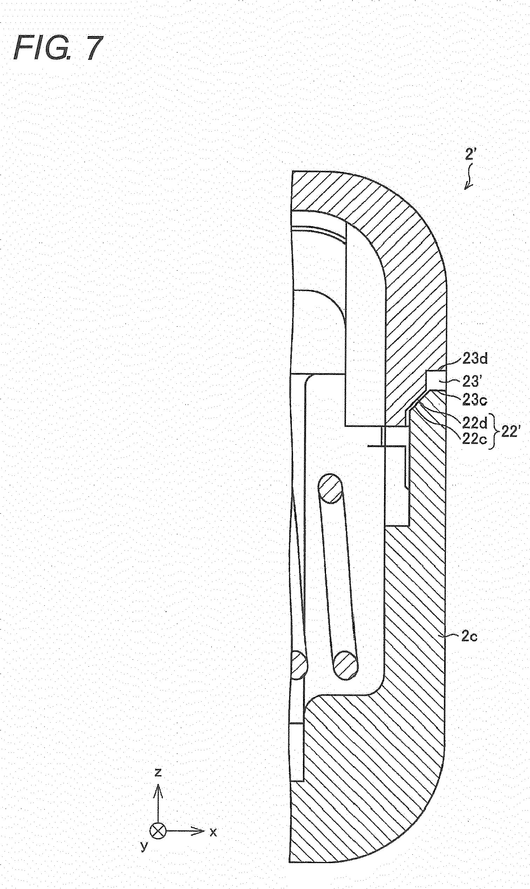

A second embodiment of the present invention will be described below with reference to Fig. 7. Fig. 7 illustrates a sectional structure of a casing of the second embodiment after first and second casing members are welded to each other. Unless otherwise noted, the terms defined in the first embodiment are also used in the second embodiment according to the definitions.

In the second embodiment, first casing member and second casing member 2d are welded to each other by a method in which the burr generated by the ultrasonic welding leaks above a welding part. Therefore, in the second embodiment, burr reservoir 23' is formed above welding part 22' of casing 2' as illustrated in Fig. 7. Burr reservoir 23' is located in an outer side in welding part 22'.

In the second embodiment, welding part 22c of first casing member 2c and welding part 22d of second casing member 2d include surfaces oblique to the ultrasonic vibration direction (Z-axis direction), and come into surface contact with each other.

In burr reservoir forming part 23c, the surface opposed to burr reservoir forming part 23d is a planar surface. Burr reservoir forming part 23d has a recessed shape. Burr reservoir 23' is formed between burr reservoir forming part 23c and burr reservoir forming part 23d.

The present invention is not limited to the embodiments, but various changes can be made without departing from the scope of the claims. It is noted that an embodiment obtained by a proper combination of technical means disclosed in different embodiments is also included in the technical scope of the present invention.

The present invention can be used in a casing of electrical instruments such as an electric tool and an in-vehicle electrical instrument.

## Claims

1. A sealed casing that is used in an electric instrument, the sealed casing (2) comprising:
a first member (2a); and
a second member (2b),
wherein the sealed casing (2) is formed by welding a welding part (22a) of the first member (2a) and the second member (2b) by ultrasonic welding, the welding part comprising a surface oblique to an ultrasonic vibration direction.

2. The sealed casing according to claim 1, further comprising:
a burr reservoir (23) in which a burr generated by ultrasonic welding is reserved, the burr reservoir (23) being located in a burr outflow direction in which the burr flows out from the welding part (22a) of the first member (2a), the burr reservoir (23) being a gap between the first member (2a) and the second member (2b).

3. The sealed casing according to claim 2, wherein a surface of the first member (2a) is flush with a contact surface of the first member (2a), the surface of the first member (2a) being a bottom surface of the burr reservoir (23), the contact surface of the first member (2a) coming into contact with the second member (2b) to specify a positional relationship between the first member (2a) and the second member (2b).

4. The sealed casing according to claim 2 or 3, wherein the burr reservoir (23) is located in an outer side in the sealed casing with respect to the welding part.

5. The sealed casing according to any one of claims 2 to 4, wherein the first member (2a) comprises a projecting portion that extends from the welding part toward a direction opposite to the burr out-flow direction, the projecting portion being located in an inner side in the sealed casing with respect to the welding part.

6. A method for producing a sealed casing (2) used in an electrical instrument, the method comprising:
a step of forming the sealed casing (2) by welding a first member (2a) and a second member (2b) by ultrasonic welding,
the first member (2a) comprising: a first welding part that comprises a surface oblique to an ultrasonic vibration direction; and a first burr reservoir forming part (23a) configured to form a gap with the second member (2b) as a burr reservoir (23) after the ultrasonic welding, the first burr reservoir forming part (23a) being located in a burr out-flow direction in which a burr generated by the ultrasonic welding flows out to the first welding part,
the second member (2b) comprising: a second welding part that is welded to the first welding part (22a); and a second burr reservoir forming part (23b) configured to form the gap with the first burr reservoir forming part (23a) as the burr reservoir (23) after the ultrasonic welding.
